## Europäisches Patentamt
## European Patent Office
## Office européen des brevets

(11) Publication number: **0 175 932**
**B1**

(12) **EUROPEAN PATENT SPECIFICATION**

(45) Date of publication of patent specification: **26.04.89**

(21) Application number: **85110595.7**

(22) Date of filing: **23.08.85**

(51) Int. Cl.⁴: **G 01 R 31/30**

(54) Method for determination of optimum parameters for stress screening of electronic components and circuit boards.

(30) Priority: **10.09.84 US 648435**

(43) Date of publication of application:
**02.04.86 Bulletin 86/14**

(45) Publication of the grant of the patent:
**26.04.89 Bulletin 89/17**

(84) Designated Contracting States:
**DE FR GB**

(56) References cited:
**GB-A-1 518 695**

(73) Proprietor: **International Business Machines Corporation**
**Old Orchard Road**
**Armonk, N.Y. 10504 (US)**

(72) Inventor: **Pugacz-Muraszkiewicz, Igor**
**9320 E. Pikes Peak Drive**
**Tucson Arizona 85710 (US)**

(74) Representative: **Atchley, Martin John Waldegrave**
**IBM United Kingdom Limited Intellectual Property Department Hursley Park**
**Winchester Hampshire SO21 2JN (GB)**

Courier Press, Leamington Spa, England.

# EP 0 175 932 B1

**Description**

Background of the invention
Field of the invention

The invention relates to stress screening of electronic components, LSI circuits, printed circuit cards or boards. More particularly, the invention according to claims 1 and 5 concerns a method to determine the optimum time and temperature for a cost effective burn-in or stress screening program for a given group of such components or cards.

Discussion of the prior art

As the complexity of electronic circuitry increases, the reliability of such circuitry is becoming critical to its use. Consequently, a significant need has developed to have quantitative information about the reliability of the circuitry embodied in electronic systems in order to have effective design evaluations, customer assurance and maintenance programs.

Substantial effort has gone into the evaluation of wear-out mechanisms in electronic circuitry. Various programs have been developed for life testing and creation of reliability models with respect to various electronic components. This is particularly true with respect to military and space systems where high reliability and long life of electronic components are paramount to cost effective utilization (see GB—A—1 518 695).

A popular early characterization of reliability was related to a so-called "bath tub" curve wherein the failure rate of a group of components was plotted against the operational time of utilization. Field data over such life testing established that, for certain components, the early life failure rate was significantly higher than the later life failure rate. Consequently, it became attractive to utilize burn-in tests to eliminate the early life failures in testing programs, whereby over the actual operational time, the components exhibited a higher reliability. This approach was successful with respect to certain types of components, particularly where adequate amounts of life test data were taken. However, it has been recognized that the bath tub curve is not a particularly accurate means of characterizing the reliability of all types of integrated circuits. Moreover, where designs of circuitry change rapidly, as in LSI circuitry, the accumulation of life test data is not possible within the design change phases in usual practice today.

Other types of screening have involved the use of elevated temperature cycles or elevated voltage cycles in order to provoke accelerated failure of components. These tests have also proved imprecise since no means was available for accurately determining what maximum safe level of temperature or voltage could be utilized in order to cause early life failures without damaging the remaining members of the group of components under test.

Temperature acceleration for chemical reactions is fairly well modeled by the Arrhennius equation:

$$R = R_0 \; EXP - \frac{E_A}{kT}$$

which states that the rates of reaction between chemical substances are a function of temperature and the characteristic constant, activation energy, which is required to cause the given substances to react with each other. The engineering community expanded the application of this equation to the temperature screening of electronic hardware by substituting the rate of chemical reaction with the failure rates of components, and found that this law holds quite well for lower temperatures, but not as well for higher temperatures. For example, see I. E. Arsenault and I. A. Roberts, "Reliability and Maintainability of Electronic Systems", Computer Science Press, 1980. The temperature range discussed in the Arsenault and Roberts article goes as high as 275°C.

The failure mechanisms of electronic hardware are bimodal and have commonly been referred to as infant mortality, freak mortality and main mortality. Various models have been developed for screening based upon the Arrhennius equation, life test data and recognition of failures or distributions of these three modes of failure. The most widely used of these models is perhaps the MIL-HDBK model developed by the U.S. Department of Defense for military application.

This model is based upon life test data with respect to a variety of components and it incorporates an Arrhennius factor which is, in effect, based upon assumed activation energy levels associated with the various failure mechanisms that are recognized to impact the group of components being tested. The MIL-HDBK model has resulted in a recommended 168 hour burn-in test which is widely followed by military suppliers and designers. The testing is performed at operational temperature, or at arbitrarily selected elevated temperatures.

Various other models are discussed by Reynolds, note "Measuring and Modeling Integrated Circuit Failure Rates", Frederick H. Reynolds, published in Reliability in Electrical and Electronic Components and Systems, North Holland Publishing Company, 1982.

It has been recognized by the applicant herein that a 168 hour burn-in temperature routine is not cost effective for commercial purposes. It has also been recognized that the use of arbitrarily selected temperatures with respect to testing of bimodal or multimodal failure mechanisms related to a given group

EP 0 175 932 B1

of electronic circuits, does not result in an optimum testing program. Thus, the amount of product which is removed by failure in such a stress testing program may include more or less than the ideal amount of infant mortality product which it is desired to take out; and it may include a great deal more of the freak mortality distribution than is desired. At the current time, cost factors prohibit effective life testing of electronic circuitry for all except expensive military systems. However, for such systems, a need still exists to predict the temperature and time necessary to do accurate life testing to remove a satisfactory percentage of infant and freak mortality and leave the components which exhibit reliability with respect to main life.

Summary of the invention

Accordingly, it is an object of the invention to describe a method for determination of optimum parameters for stress screening of electronic components, printed circuit cards and boards and LSI circuitry.

It is a further object to describe a methodical approach for determination of the optimum temperature and optimum time for temperature accelerated screening of such components to achieve a desired effect, such as elimination of a predetermined portion of infant mortality failures among such components.

These and other objects and methods are achieved in a method which utilizes a statistically suitable group of components or circuit boards of a given type. The selected group is divided into three samples. The first sample is subjected to a temperature step stress test. Thus, the sample of cards is step stressed by increasing the temperature at each readout time by a predetermined level. The readouts are taken at constant time intervals. Due to the expected log normal distribution of failures, the temperature step stress test produces a straight line if the results are plotted on log normal paper. Consequently, the point at which the failure rate suddenly increases, causing deviation from the straight line, determines the upper temperature limit for safely testing for the selected mode. The preceding temperature point, therefore, is the upper safe limit for accelerated temperature testing.

The second and third samples of cards are each subjected to life testing at a different temperature selected to be below the safe testing range and separated by a 20°—30° range.

Each of the samples of cards is stressed at a constant temperature with the cards under power. The time to each failure is carefully monitored. This test, when plotted on log normal paper, again produces a straight line if there is unimodal distribution of failures. If the distribution is bimodal, an S shaped curve is obtained, and a double S plot is observed for trimodal distributions. From these shapes, individual subdistributions of failures can be extracted and the percentages of product belonging to each subdistribution can be determined. The percentages of product associated with the respective modes of distribution failure are found at the inflection points of the S curves as is explained in detail hereinafter.

Since in each of the life test experiments, the temperature and time is known, plotting the temperature and time values on Arrhennius paper provides the value of activation energy associated with each distribution mode for burn-in screening at a selected temperature and field hours equivalent of projected life.

The activation energy can be verified by calculation utilizing a novel form of the Arrhennius equation developed by applicant.

The method described is applicable for burn-in screening to eliminate infant mortality in the case of bimodal distributions, but could be utilized for removal of freak mortality or life mortality testing in the event that such as required. However, at this time it is believed that cost effective testing for these parameters is not likely with respect to most commercial products utilizing available testers.

Brief description of the drawings

Other features and advantages of the invention are described hereinafter in connection with the accompanying drawings in which:

Figure 1 illustrates the plot of a temperature step stress test carried out with respect to a sample of 40 logic printed circuit boards in the preferred embodiment;

Figure 2 is a graph illustrating the results of a 120°C life test carried out with respect to a sample of 40 logic printed circuit boards tested under the process of the preferred embodiment of the invention;

Figure 3 is a graph representing life test results taken at 135°C with respect to a sample size of 50 logic printed circuit boards tested as the third sample tested in the process described herein;

Figure 4 is a plot illustrating the activation energy calculated in accordance with the experiment at a use temperature of 45°C and a predetermined field hours equivalent of 3,000; and

Figure 5 is the field projection derived from the two life tests using the activation energy values obtained for infant mortality and freak mortality subdistributions. The use temperature was estimated to be 45°C.

Detailed description of the invention

Referring now to the drawings and the experimental data included hereinafter, a preferred embodiment of the invention is described.

One hundred thirty cards of a given part number were used throughout the experiments. The cards were divided into three samples. A first sample was subjected to temperature stress testing and the second and third samples were subjected to life testing at different temperatures.

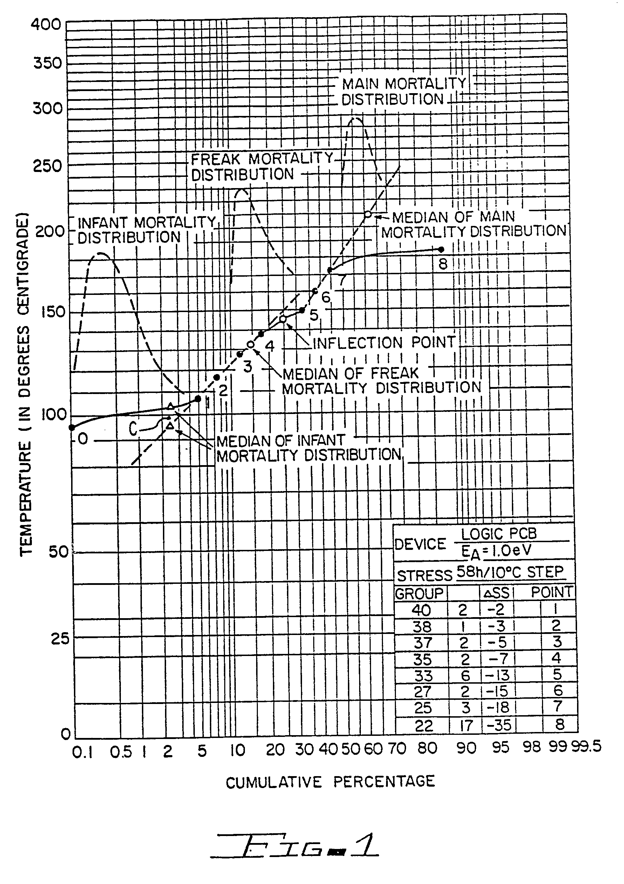

The temperature step stress test was used to establish the upper temperature limit for screening cards. Table 1 summarizes the results of the temperature stress test, and Figure 1 represents a plot of the results on log normal paper. As was previously explained, it is expected that failures of electronic components due to a given failure mode will follow a log normal distribution. Accordingly, the failure rate or characteristics when plotted on log normal paper would be expected to follow a straight line. The experimental data represented by points 1—4 in Figure 1 bear this out.

TABLE 1

Step stress failure summary

| Card S/N | Burn-in condition | Previous B/I adjusted equivalent±2° | Nature of failure | Failing component | Number of failures | Retest after repair |
|---|---|---|---|---|---|---|
| 37 | 116 hr/85°C thru | 58 hr/107°C | Func. | D | 2 | TOK |
| 57 | 58 hr/95°C | | Func. | S | | TOK |
| 30 | 116 hr/85°C thru 58 hr/105°C | 58 hr/118°C | Func. | S | 1 | TOK |
| 55 | 116 hr/85°C thru | 58 hr/128°C | Func. | D | 2 | TOK |
| 56 | 58 hr/115°C | | Func. | S | | TOK |
| 31 | 116 hr/85°C thru | 58 hr/139°C | El. Open | Raw Card | | TOK |
| 29 | 58 hr/125°C | | V/M Del. | Raw Card | | TOK |
| 36 | | | Func. | Handle damage | 2(4) | TOK |
| 42 | | | Func. | Dut. Fast. Utl. | | TOK |
| 25 | 116 hr/85°C thru | 58 hr/150°C | Func. | Capacitor | 6 | TOK |
| 26 | 58 hr/135°C | | Func. | S | | TOK |
| 32 | | | Func. | D | | TOK |
| 38 | | | Func. | Not Ident. | | FAIL |
| 41 | | | Func. | Not Ident. | | FAIL |
| 54 | | | Func. | Not Ident. | | TOK |
| 24 | 116 hr/85°C thru | 58 hr/160°C | Func. | Not Ident. | 2 | FAIL |
| 51 | 58 hr/145°C | | Func. | D | | TOK |
| 44 | 116 hr/85°C thru | 58 hr/171°C | Func. | | 3 | TOK |
| 52 | 58 hr/155°C | | Func. | Not Ident. | | FAIL |
| 53 | | | Func. | Not Ident. | | FAIL |
| MANY | 116 hr/85°C thru 58 hr/165°C | 58 hr/183°C | Func. | Not Ident. | 17 | FAIL |

However, point 5 deviates from the dotted straight line and therefore comprises an over stress point with regard to the weaker population of cards of about 25 percent of the total population. Since we are interested in the weaker population comprising infant mortality, point 5 is of significance to use. Thus, it is evident from Figure 1 that the over stress point for the weaker distribution is point 5, corresponding to a temperature of 150°C. Therefore, point 4 appears to be the upper safe temperature limit for stress testing of cards of this part number. Point 4 corresponds to a temperature of about 140°C.

It should be noted that points 5, 6 and 7 exhibit a straight line characteristic with respect to the stronger population or the remaining 75 percent of the cards. Deviation from that straight line is represented by point 8 corresponding to about 170°C, at which temperature massive card failures occurred. This deviation indicates that a trimodal failure distribution occurred with respect to the particular card under test. The information is not significant with respect to infant mortality screening, but could be useful in connection with life testing if the costs justified such a program.

Life tests were carried out with respect to the second and third samples of cards of 120°C and 135°C, respectively. These temperatures were selected since they are lower than the maximum stress testing temperature identified by the step stress test, and they are separated by a reasonable range whereby data obtained in each of the life tests can be utilized to find the activation energy for stress testing with respect to the infant mortality failure mode.

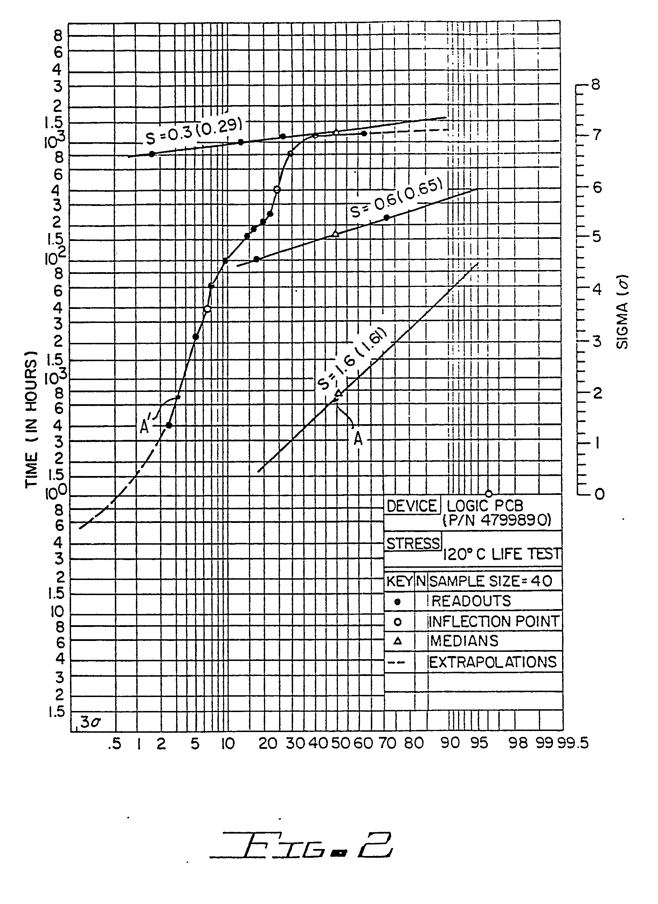

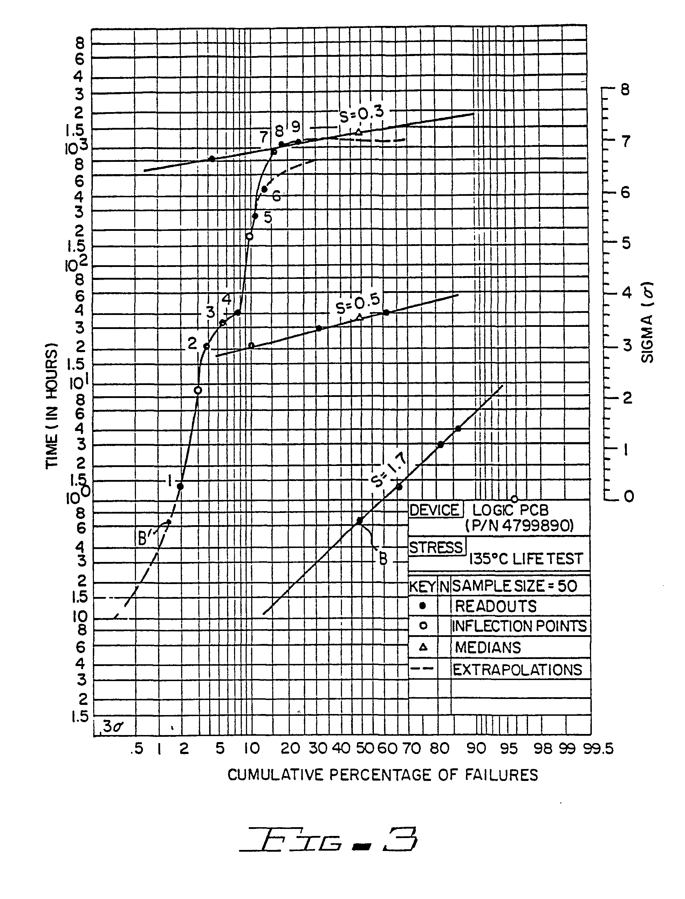

The results of the 120° test are represented in Figure 2 and the results of the 135° life test are represented in Figure 3. It is evident from Figure 2 that the first life test plot forms a double S shape with inflection points at about 6.5 percent and 25.0 percent cumulative failure levels. The lower figure corresponds to infant morality.

The plot of Figure 3 also represents a double S shape for trimodal distribution with inflection points at 3 percent and 10 percent cumulative failure levels, respectively. Infant morality is indicated by the 3 percent figure.

With a small sample size or small percentage of early life failures, it is common not to have the lower branch of the S-shape corresponding to the early life fails. This portion of the first S-shape can be reconstructed once the log-normal distribution is verified by a straight line as in Figure 3. The segment of the first S-shape between point 1 and the first inflection point (between points 1 and 2) belongs to the infant mortality subdistribution. It is based on real experimental data.

By taking three optional points from this segment and calculating what percentages of the total of 3 percent infant mortality the chosen 3 points constitute, a straight line is constructed. Such a line is shown to the right of data point 1. Further, by extending this line to intersect with 50 percent cumulative failure, the median time to failure for infant mortality subdistribution is obtained. (Point B). Considering the fact that 50 percent of 3 percent is 1.5 percent, point $B^1$ is located. By repetition of this exercise for cumulative percentages which are less than 50, additional points are found and the lower branch of the S-shape is reconstructed, as shown.

Since the time to failure needed to establish the values of activation energy must be based on medians (Points B, $B^1$) this novel procedure is very helpful.

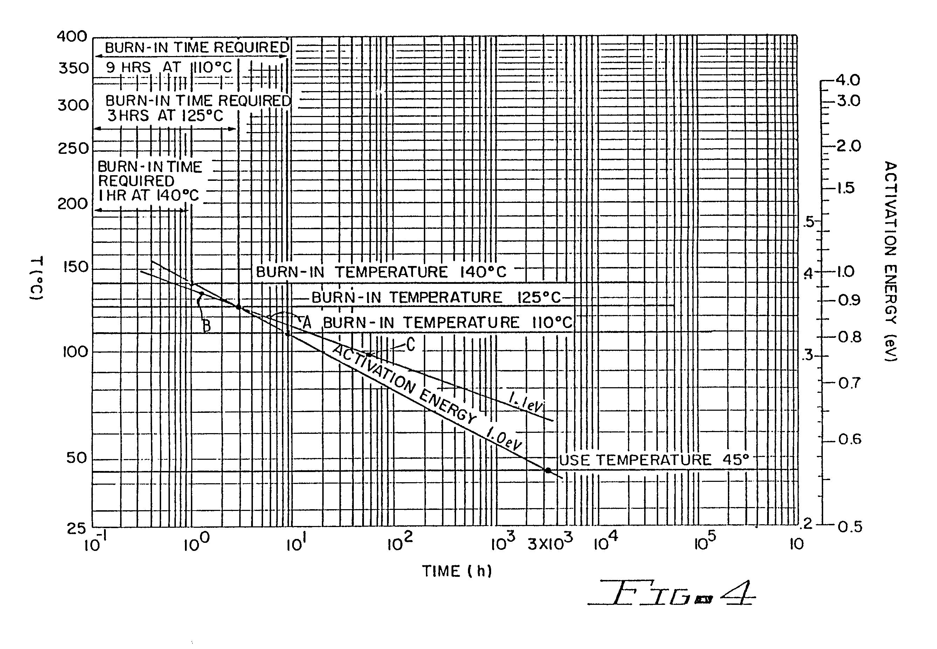

The activation energy for the infant mortality failure mode can be determined by plotting point A of Figure 2 and point B of Figure 3 on the Arrhennius graph illustrated in Figure 4. The activation energy is plotted with respect to a use temperature of 45° at a point established by a preselected value of 3,000 field hours equivalent use. Consequently, at a burn-in temperature of 140° 1 hour of burn-in time would be required; whereas at a burn-in temperature of 125° a burn-in time of 3 hours would be optimum. If a burn-in temperature of 110° were desired, then a burn-in temperature of 9 hours would be ideal.

The activation energy associated with the infant mortality failure mode can also be calculated utilizing a modification of the Arrhennius equation indicated hereinafter.

To make sure our data for the values of activation energies were accurate, we verified them mathematically using the Arrhennius Model.

The Arrhennius Model is:

$$R = R_0 \; EXP - \frac{E_A}{kT} \qquad (1)$$

By taking two values of R for two different temperatures, $T_1$ and $T_2$ ($T_2 > T_1$) and by dividing $R_2$ by $R_1$, we obtain:

$$\frac{R_2}{R_1} = \frac{R_0}{R_0} \; \frac{EXP-\dfrac{E_A}{kT_2}}{EXP-\dfrac{E_A}{kT_1}} = \frac{EXP-\dfrac{E_A}{kT_2}}{EXP-\dfrac{E_A}{kT_1}} \qquad (2)$$

Further, by a simple operation, the minus sign is eliminated and one gets:

$$\frac{R_2}{R_1} = \frac{EXP \; \dfrac{E_A}{kT_1}}{EXP \; \dfrac{E_A}{kT_2}} \qquad (3)$$

5

Hence,

$$\frac{R_2}{R_1} = EXP(\frac{E_A}{kT_1} - \frac{E_A}{kT_2}) \tag{4}$$

Therefore:

$$\frac{R_2}{R_1} = EXP[\frac{E_A}{k}(\frac{1}{T_1} - \frac{1}{T_2})]$$

or

$$\frac{R_2}{R_1} = EXP[\frac{E_A}{k}(\frac{T_2-T_1}{T_1T_2})] \tag{5}$$

Dividing cumulative failure rates R from any two experimental plots by the respective times, one obtains the instantaneous failure rates $\lambda_2$, $\lambda_1$, and the equation becomes:

$$\frac{\lambda_2}{\lambda_1} = EXP\frac{E_A}{k}\frac{(T_2-T_1)}{T_1T_2} \tag{6}$$

$$\frac{\lambda_2}{\lambda_1} = (AF) \text{ (acceleration factor)}$$

Taking natural logarithms on both sides of the equation (6) leads to an expression for activation energy, $E_A$, as a function of two different failure rates and respective absolute temperatures:

$$E_A = (\ln\lambda_2 - \ln\lambda_1) \, k\frac{T_1T_2}{T_2-T_1} \tag{7}$$

where

$\lambda_2$=failure rate at temperature $T_2$
$\lambda_1$=failure rate at temperature $T_1$
$k=8.623\times10^{-5}$ eV/°K (Boltzman's Universal Constant)
$T_2 > T_1$ and $\lambda_2 > \lambda_1$

By combining the failure data from the individual plots of the step stress and two life tests, we have the following values for failure rates at medians:

$\lambda'_1$=0.0431%/h step stress at 98°C/58 hours
$\lambda'_2$=0.387%/h life Test at 120°C/7.55 hours
$\lambda'_3$=1.07%/h life Test at 135°C/1.4 hours
By the application of formula (7):

$$E'_A(135/120) = 1.017 \times 8.623 \times \frac{160344}{15\times10^5} = 0.937 \text{ eV}$$

$$E''_A(135/98) = 3.21 \times 8.623 \times \frac{151368}{37\times10^5} = 1.13 \text{ eV}$$

$$E'''_A(120/98) = 2.19 \times 8.623 \times \frac{147658}{22\times10^5} = 1.26 \text{ eV}$$

and the average of these three values amounts to 1.109 eV, which is in agreement with the experimental best estimate of 1.1 eV.

Thus, the experimental value of activation energy of 1.1 is essentially verified by the calculated empirical value of 1.109 eV.

Similar exercises could be carried out with respect to the freak mortality and main mortality failure modes in order to determine activation energies for those failure modes. The calculated activation energy values would then permit determination of the temperature and time for a life testing model if that is desired. If should be recognized, however, that life testing would utilize a substantial increase in testing time and the resulting expense would probably be prohibitive for all but high quality military requirements.

It is believed that the process defined herein comprises an effective methodical approach for identifying optimum time.

It is believed that the process defined herein comprises an effective methodical approach for identifying optimum time and temperature parameters for burn-in in a cost effective card screening procedure.

A detailed description of the experimental examples is set forth hereinafter.

Experimental data example 1

One hundred forty cards, P/N 4799890 were used throughout the experiments and inspected according to standard manufacturing procedures, and in addition, box tested to avoid zero time functional failures.

The following conditions prevailed throughout the experiment. The burn-in was static. The relative humidity never exceeded 4 percent. The cards were powered by providing +5.5 volts and ground to the pins according to the logic diagram. The +5.5 volts was measured at the pins of the mother boards at room ambient temperature of about 25°C after the boards were populated. To ensure that every card was plugged in properly and received power, the card were inserted hot with +5.0 volts applied to the boards according to the logic diagram. Power to the cards was disconnected at the moment of their removal from the chamber. Readouts were taken by means of the functional box testing. All the values are chamber ambient temperatures.

The readouts during step stress were conducted on NIT, ASTRA, MPTS prime testers and in the functional box. Due to unreasonably long testing cycle and other inadequacies of testing on discrete testers, the readouts in the experiments beyond step stress were limited to the functional box test.

1. Step stress

The temperature step stress was performed in 10°C steps and with the constant time of 58 h per step with the exception of an 85°C prestress conducted for 116 hours. In this experiment 40 cards from one lot were stepwise burned-in up to 165°C chamber ambient, and failures were removed from the sample at the time of each readout.

Table 1 summarizes the results. The third column shows the corrected temperature which was established on the basis of assumed activation energy of 1.0 eV. The accuracy of ±2°C covers adequately 0.8 to 1.2 eV range. Column 5 represents the readouts of discrete testers, which are necessary for identification of failing components and card repair. Column 7 shows the functional test results after the repair action was taken, which is at the moment the only proof that indeed the identified component has caused card failure.

The results are plotted on log normal paper in Figure 1. After the stress step of 139°C/58 h, (raw 4) 4 failures have been identified and removed from the sample. Failure analysis of failing cards performed after completion of the experiment has identified 2 cards as legitimate failures. The reduction by two of the sample size going into the next step moves the readout points 4 and higher towards lower a cumulative percent of failure numbers but it does not change the overall picture. From the plot in Figure 1 it is immediately apparent that we are dealing with: a) trimodal distribution and b) the total population is split approximately 1 to 3. The first 25 percent of the product represents early failures, that is infant mortality plus freak mortality, while the remaining 75 percent represents the strong main distribution (MN).

It is also evident that above 170°C the fallout rate is extremely high. The point 8 represents the percentages with the sample correction at point 4. The front portion of the plot would remain about the same with only a slight change of the slope, which would reflect an increased percentage of early failures.

There appear to be two overstress points. They are: point 5 which is overstress with regard to the weaker population of about 25 percent, and point 8 which is overstress for the stronger population of the remaining 75 percent of cards. Since we are interested in the weaker populations, point 5 is of primary concern.

2. Life test

The life test was carried out with respect to 40 cards at a temperature of 120°C as dictated by the step stress experiment. Test results are plotted in Figure 2. The objective of life test is to establish the failure distributions and the activation energy values corresponding to them. In order to accomplish the latter, at least 3 data points are desired. One point for each distribution is obtained from step stress, another from the first life test, which was decided to be 120°C and the third point should be obtained from a life test at another temperature within 140°C.

These cards were burned-in at 120°C with predetermined readout times. In addition to box test readouts, the voltage change on the power supply side were monitored. It was found that for each card which developed an electrical short, the voltage would drop by 0.013 V on the average. This crude method was helpful in obtaining some intermediate points, which allowed to draw the curve with greater confidence.

It is evident from Figure 2 that the plot forms a double S shape with the inflection points at about 6.5 percent and 25.0 percent cumulative failure. The 25.0 percent is consistent with the estimated 25 percent in Figure 1.

The three distributions observed are infant mortality which constitutes 6.5 percent of total population with the standard deviation estimate of S=1.6; freak distribution of about 18.5 percent with the estimate S=0.7; and main distribution of 75.0 percent of total population with an estimate S=0.3.

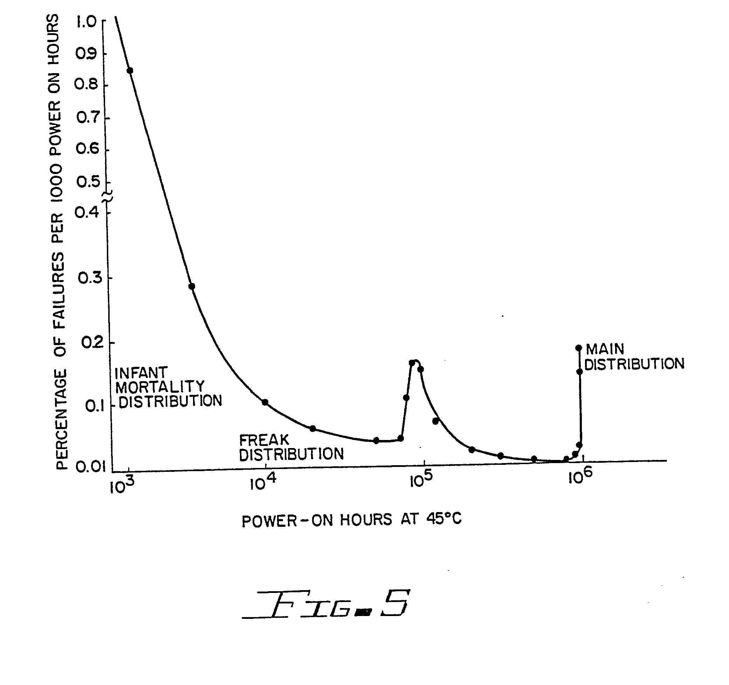

Figure 5 is a semi-quantitative illustration of the three observed distributions. Because of a large variety of components, and hence, a board spectrum of possible failure mechanisms, it is expected that the apparent activation energies for the three different distributions are going to be different. The fact that observed modes do not belong to the same distribution, i.e. different values for the estimates of standard deviations, indicates just that.

The cards are identical in every respect and the only factor which allows differentation is the different combination of the failure mechanisms causing them to fail. Under such circumstances the possibility of activation energies being similar is very remote indeed.

Therefore, in consideration of burn-in screening, each distribution should stand on its own merits. That is to say that the activation energy characteristic for failures in the main distribution cannot be used in establishing burn-in conditions aimed at removal of infant mortality distribution or a part of it or for removal of freak distribution.

The second life test involved 50 cards belonging to a different lot. Results are plotted in Figure 3. This life test was carried out at 135°C. Although it has not been completed to reach 50 percent cumulative failures, the 12.5 percent fallout and the first S-shape was attained. This allows the use of time and temperature data points to establish the activation energy for infant mortality distribution of average of 4.75 percent and the freak distribution of about 13.5 percent.

3. Activation energy

The temperature acceleration is extremely sensitive to the activation energy. Therefore, the determination of activation energy must be very accurate. Since the life test at 135°C was not completed, only infant mortality and freak distributions produce sufficient data to determine the range of activation energy applicable to these subdistributions.

Reading the temperature and times from Figure 1, Figure 2 and Figure 3, Points A, B and C for the cumulative percentages of fallout, applying short B/l time correction to the 135°C test data and plotting the points on Arrhennius paper, we obtain the results illustrated in Figure 4.

The line determined by the Points A, B and C from Figure 1, Figure 2 and Figure 3 is inclined under the angle corresponding to the value of the activation energy of 1.1 eV. This is the experimental value for infant mortality failures.

As to the main distribution, the Ea can be based only on two data points from the two completed experiments. The values of Ea based on median time to failure are:

Freak distribution Ea=1.3 eV
Main distribution Ea=0.55 eV

Again, the main distribution data are based partly on an extrapolated step stress curve, which lowers our confidence. Since we are dealing with a complex structure in terms of variety of components and possible failure mechanisms, the activation energy is called apparent.

Since the activation energies for various types of components are expected to be within 0.5 eV to 2.0 eV an additional arbitrary line for the value of 1.0 eV is drawn in Figure 4 to illustrate the technique for determination of the shortest stress screening time to achieve 3000 field hours equivalent, for a given field use temperature and desired screening temperature limit. If our experimental value of 1.1 eV was applied, the screening times would be shorter.

Conclusion

The combination of step stress and life test reveal multimodal distribution of failures. These experiments allow determination of the percentage of potential weaklings, determination of activation energy for each mode observed in the product, and as a consequence, determination of burn-in parameters such as temperature and time to achieve desired effect of screening.

Hereinbefore there has been described a method for determination of optimum parameters for stress screening of electronic components, printed circuit cards or circuit boards. A statistically satisfactory group of cards is selected and divided into three samples. The first sample is subjected to temperature step stress testing to determine an upper temperature limit for stress screening. The second and third samples are each subjected to life tests at a differing lower temperature in order to determine the optimum activation energy for testing. The activation energy is calculated from a novel version of Arrhennius model and used to determine the ideal burn-in time at a preselected operational or elevated temperature to provide optimum stress screening.

**Claims**

1. A method for determining maximum temperature for stress screening of electrical devices including the steps of:

a) applying a temperature step-stress test to a selected sample of powered up devices and identifying and removing all failed devices between each temperature step,

b) plotting the cumulative failure rate versus temperature results of the test on log normal paper, and

c) identifying the point at which the plot deviates from linearity as the maximum test temperature for devices of the selected group type.

2. A method of claim 1 further including the steps of:

a) performing life tests on two additional samples of the devices, each at a different temperature below the identified maximum test temperature,

b) plotting the cumulative failure rate versus time results of each test, and

c) determining the median time to failure for an infant mortality failure subdistribution for each life test plot.

3. The method of claim 2 further including the steps of:

a) plotting the median time temperature point established for each life test of Arrhennius paper, and

b) connecting the established points with a straight line to determine ideal activation energy for stress screening of the devices.

4. A method of claim 2 further including the step of calculating the ideal activation energy for stress screening of the devices where:

$$E_A = (\ln\lambda_2 - \ln\lambda_1)k\frac{T_1 T_2}{T_2 - T_1}$$

where

$\lambda_2$ = failure rate at temperature $T_2$

$\lambda_1$ = failure rate at temperature $T_1$

$k = 8.623 \times 10^{-5}$ eV/°K (Boltzman's Universal Constant)

$T_2 > T_1$ and $\lambda_2 > \lambda_1$

5. A method for determining optimum parameters for stress screening of electrical devices including the following steps:

selecting a group of devices and dividing it into three samples of statistically reasonable size,

in a heating chamber applying standard power to the devices of a first sample and applying heat by incremental steps of equal time base,

between each heat application step testing all devices in the sample to identify and remove all failed devices,

plotting the cumulative failure versus temperature results of the test on log normal paper,

continuing the application of additional temperature steps until the plot deviates from linearity, and identify the temperature of deviation as the maximum testing temperature for devices of this type.

6. The method of claim 5 further including the steps of:

in a heating chamber applying standard power to the devices of a second sample and applying heat at a selected temperature below the identified maximum test temperature over equal time intervals,

plotting the cumulative failure rate versus time results of the test,

identifying an infant mortality failure subdistribution from the plot, and

determining the median time to failure for the infant mortality subdistribution.

7. The method of claim 6 wherein the steps of claim 6 are repeated with respect to a third sample of the devices at a second temperature below the identified maximum test temperature and different from the temperature utilized in claim 6 by a minimum of 10°C.

8. The method of claim 7 further including the steps of:

plotting the median time/temperature points from each life test on Arrhennius paper and connecting the points with a straight line to determine ideal activation energy for use in stress screening of the devices.

9. The method of claim 7 further including the step of calculating the activation energy to be used in further stress screening of the devices where:

$$E_A = (\ln\lambda_2 - \ln\lambda_1)k\frac{T_1 T_2}{T_2 - T_1}$$

where

$\lambda_2$ = failure rate at temperature $T_2$

$\lambda_1$ = failure rate at temperature $T_1$

$k = 8.623 \times 10^{-5}$ eV/°K (Boltzman's Universal Constant)

$T_2 > T_1$ and $\lambda_2 > \lambda_1$

10. The method of claim 7 where the temperature selected for the second life test is in the range of 20°—30° different from the temperature selected for the first life test.

## Patentansprüche

1. Verfahren zum Bestimmen der Maximaltemperatur für die Belastungsprüfung von elecktrischen Geräten, mit folgenden schritten:

a) Anwenden eines schrittweisen temperaturbelastungstests aur eine ausgewählte Stichprobe eingeschalteter Geräte sowie Identifizieren und Entfernen aller ausgefallenen Geräte von jedem Temperaturschritt,

b) Auftragen der Testergebnisse hinsichtliche der Kumulativen Ausfallrate über der Temperatur auf Papier mit logarithmischem Maßstab und

c) Identifizieren des Funktes, an dem die aufzutragende Kurve von einer linearen Forme abweicht, als die maximale Testtemperatur für Geräte vom Typ der ausgewählten Gruppe.

2. Verfahren nach Anspruch 1, mit folgenden weiteren Schritten:

a) Durchführen von Lebensdauertests an zwei zusätzlichen Stichproben der Geräte jeweils bei einer unterschiedlichen Temperatur unterhalb der identifizierten maximalen Testtemperatur,

b) Auftragen der Ergebnisse jedes Tests hinsichtlich der kumulativen Ausfallrate über der Zeit und

c) Bestimmen der Medianzeit bis zum Ausfall als eine Ausfall-Unterstatistik für die Anfangs-Ausfall-wahrscheinlichkeit für jede Lebenedauertestkurve.

3. Verfahren nach Anspruch 2, mit folgenden weiteren Schritten:

a) Auftragen des für jeden Lebensdauertest erstellten Medianzeit/Temperatur - Punktes auf Arrhenius-Papier und

b) Verbinden der erstellten Punkte mit einer geraden Linie, um eine ideale Aktivierungsenergie für die Belastungsprüfung der Geräte zu bestimmen.

4. Verfahren nach Anspruch 2, mit folgendem weiteren Schritt:

Berechnen der idealen Aktivierungsenergie für die Belastungsprüfung der Geräte nach

$$E_A = (\ln\lambda_2 - \ln\lambda_1)k\ T_1T_2/(T_2 - T_1)\ .$$

mit

$\lambda_2$ = Ausfallrate bei Temperatur $T_2$

$\lambda_1$ = Ausfallrate bei Temperatur $T_1$

$k = 8,623 \times 10^{-5}$ eV/°K (Boltzmann-Konstante),

$T_2 > T_1$ und

$\lambda_2 > \lambda_1$

5. Verfahren zum Bestimmen optimaler Parameter für die Belastungsprüfung elektrischer Geräte, mit folgenden Schritten:

Auswählen einer Gerätegruppe und Einteilen der Gerätegruppe in drei Stichproben von statistisch aussagekräftiger Größe,

Beaufschlagen der Geräte einer ersten Stichprobe mit Standardleistung in einer Heizkammer und Zuführen von Wärme in inkrementellen Schritten in gleichen Zeitintervallen.

Testen aller Geräte der Stichprobe vor jedem Wärmezufuhrschritt, um alle ausgefallenen Geräte zu identifizieren und zu entfernen,

Auftragen der Testergebnisse hinsichtliche der kumulativen Ausfallrate über der Temperatur auf Papier mit logarithmischem Maßstab,

Fortsetzen der Wärmezufuhr in zusätzlichen Temperaturschritten, bis die aufzutragende Kurve von einer linearen Form abweicht, und

Identifizieren der Temperatur am Abweichungspunkt als die maximale Testtemperatur für Geräte dieses Typs.

6. Verfahren nach Anspruch 5, mit folgenden weiteren schritten:

Beaufschlagen der Geräte einer zweiten Stichprobe mit Standardleistung in einer Heiskammer und Zuführen von Wärme bei einer ausgewählten Temperatur unterhalb der identifizierten maximalem Testtemperatur in gleichen Zeitintervallen,

Auftragen der Testergebnisse hinsichtlich der kumulativen Ausfallrate über der Zeit,

Identifizeren einer Ausfall-Unterstatistik für die Anfangs-Ausfall-wahrscheinlichkeit aus der aufzutragenden Kurve und

Bestimmen der Medianzeit bis zum Ausfall für die Unterstatistik der Anfangs-Ausfallwahrscheinlichkeit.

7. Verfahren nach Anspruch 6, wobei die Schritte des Anspruchs 6 bezüglich einer dritten Stichprobe wiederholt werden bei einer zweiten unterhalb der identifizierten maximalen Testtemperatur liegenden Temperatur, die sich von der nach Anspruch 6 verwendeten Temperatur um mindestens 10°C unterscheidet.

8. Verfahren nach Anspruch 7, mit folgenden weiteren Schritten:

Auftragen der Medianzeit/Temperatur-Punkte aus jedem Lebensdauertest auf Arrhenius-Papier und

**EP 0 175 932 B1**

Verbinden der Punkte mit einer geraden Linie, um eine ideale Aktivierungsenergie zur Werwendung bei der Belastungsprüfung der Geräte zu bestimmen.

9. Verfahren nach Anspruch 7, mit folgendem weiteren Schritt:

Berechnen der in weiteren Belastungsprüfungen der Geräte zu werwendenden Aktivierungsenergie nach

$$E_A = (\ln\lambda_2 - \ln\lambda_1)k\ T_1 T_2 / (T_2 - T_1)$$

mit

$\lambda_2$ = Ausfallrate bei Temperatur $T_2$
$\lambda_1$ = Ausfallrate bei Temperatur $T_1$
$k = 8,623 \times 10^{-5}$ eV/°K (Boltzmann-Konstante),
$T_2 > T_1$ und
$\lambda_2 > \lambda_1$

10. Verfahren nach Anspruch 7, wobei die für den zweiten Lebensdauertest gewählte Temperatur sich um 20° bis 30°C von der für den ersten Lebensdauertest gewahlten Temperatur unterscheidet.

**Revendications**

1. Procédé pour la détermination d'une température maximum pour le tri par contrainte de dispositifs électriques comprenant les étapes suivantes:

a) appliquer un test de contrainte par palier de température à un échantillon choisi de dispositifs alimentés et identifier et éliminer tous les dispositifs défaillants entre chaque palier de température,

b) tracer les résultats de taux de défaillance cumulatif en fonction de la température du test sur papier logarithmique normal, et

c) identifier le point où le tracé dévie de la linérarité comme la température de test maximum pour les dispositifs du type de groupe choisi.

2. Procédé selon la revendication 1, comprenant de plus les étapes suivantes:

a) réaliser des tests de durée de vie sur deux échantillons supplémentaires de dispositif, chacun à une température différente en-dessous de la température de test maximum identifiée,

b) tracer les résultats de taux de défaillance cumulatif en fonction du temps de chaque test, et

c) déterminer le temps moyen de défaillance pour une sous-distribution de défaillance en mortalité infantile pour chaque tracé de test de durée de vie.

3. Procédé selon la revendication 2, comprenant de plus les étapes suivantes:

a) tracer le point de temps/température moyen établi pour chaque test de durée de vie sur papier Arrhennius, et

b) relier les points établis par une ligne droite pour déterminer l'énergie d'activation idéale pour le tri par contrainte des dispositifs.

4. Procédé selon la revendication 2, comprenant de plus l'étape consistant à calculer l'énergie d'activation idéale pour le tri par contrainte des dispositifs où:

$$E_A = (\ln\lambda_2 - \ln\lambda_1)k\ T_1 T_2 / (T_2 - T_1)$$

où

$\lambda_2$ = taux de défaillance à la température $T_2$
$\lambda_1$ = taux de défaillance à la température $T_1$
$k = 8,623 \times 10^{-5}$ eV/°K (Constante Universelle de Boltzman)
$T_2 > T_1$ et $\lambda_2 > \lambda_1$

5. Procédé pour la détermination des paramètres optimums pour le tri par contrainte de dispositifs électriques comprenant les étapes suivantes:

choisir un groupe de dispositifs et le diviser en trois échantillons de taille statistiquement raisonnable,

dans une chambre d'échauffement, appliquer une puissance standard aux dispositifs d'un premier échantillon et appliquer la chaleur par paliers incrémentiels à même durée,

entre chaque palier d'application de chaleur, tester tous les dispositifs dans l'échantillon pour identifier et éliminer tous les dispositifs défaillants,

tracer les résultats de défaillance cumulative en fonction de la température du test sur papier logarithmique normal,

continuer l'application de paliers de température supplémentaires jusqu'à ce que le tracé défie de la linéarité, et

identifier la température de déviation comme la température de test maximum pour les dispositifs de ce type.

6. Procédé selon la revendication 5, comprenant de plus les étapes suivantes:

dans une chambre d'échauffement, appliquer une puissance standard aux dispositifs d'un second échantillon et appliquer la chaleur à une température choisie en-dessous de la température de test maximum identifiée sur des intervalles de temps égaux,

tracer les résultats de taux de défaillance cumulatif en fonction du temps du test,

identifier une sous-distribution de défaillance en mortalité infantile à partir du tracé, et

11

déterminer le temps moyen de défaillance pour la sous-distribution en mortalité infantile.

7. Procédé selon la revendication 6, dans lequel les étapes de la revendication 6 sont répétées dans le cas d'un troisième échantillon de dispositifs à une seconde température en dessous de la température de test maximum identifiée et différente de la température utilisée dans la revendication 6 d'un minimum de 10°C.

8. Procédé selon la revendication 7, comprenant de plus les étapes suivantes:

tracer les points de temps/température moyen de chaque test de durée de vie sur papier Arrhennius et relier les points par une ligne droite pour déterminer l'énergie d'activation idéale pour l'utilisation dans le tri par contrainte des dispositifs.

9. Procédé selon la revendication 7, comprenant de plus l'étape consistant à calculer l'énergie d'activation destinée à un tri par contrainte supplémentaire des dispositifs où:

$$E_A = (\ln\lambda_2 - \ln\lambda_1)k\ T_1T_2/(T_2 - T_1)$$

où

$\lambda_2$ = taux de défaillance à la température $T_2$
$\lambda_1$ = taux de défaillance à la température $T_1$
$k = 8,623 \times 10^{-5}$ eV/°K (Constante Universelle de Boltzman)
$T_2 > T_1$ et $\lambda_2 > \lambda_1$

10. Procédé selon la revendication 7, où la température choisie pour le second test de durée de vie est différente avec une gamme de 20°—30° de la température choisie pour le premier test de durée de vie.

_FIG-1_

| DEVICE | LOGIC PCB $E_A = 1.0 eV$ | | |
|---|---|---|---|
| STRESS | 58h/10°C STEP | | |
| GROUP | | ΔSS | POINT |
| 40 | 2 | -2 | 1 |
| 38 | 1 | -3 | 2 |
| 37 | 2 | -5 | 3 |
| 35 | 2 | -7 | 4 |
| 33 | 6 | -13 | 5 |
| 27 | 2 | -15 | 6 |
| 25 | 3 | -18 | 7 |
| 22 | 17 | -35 | 8 |

_FIG - 2_

Fig-3

FIG 4

FIG. 5